# EUROPÄISCHE PATENTSCHRIFT

(11) **EP 0 932 944 B1**
(45) Veröffentlichungstag und Bekanntmachung des Hinweises auf die Patenterteilung: **13.03.2002**
(21) Anmeldenummer: 97909195.6
(22) Anmeldetag: 25.09.1997
(51) Int. Cl.: H04B 5/00, G06K 19/07, G06K 7/08

(54) **DATENÜBERTRAGUNGSSCHALTUNG MIT EINER STATION UND MIT EINER ANTWORTSCHALTUNG**
DATA-TRANSMISSION CIRCUIT WITH A STATION AND A RESPONSE CIRCUIT
CIRCUIT DE TRANSMISSION DE DONNEES COMPORTANT UNE STATION ET UN CIRCUIT DE REPONSE

(30) Priorität: 15.10.1996 DE 19642568
(43) Veröffentlichungstag der Anmeldung: 04.08.1999
(73) Patentinhaber: Infineon Technologies AG, 81669 München (DE)
(72) Erfinder: REINER, Robert, D-85579 Neubiberg (DE)
(74) Vertreter: Fischer, Volker, Dipl.-Ing.
(86) Internationale Anmeldenummer: DE9702187
(87) Internationale Veröffentlichungsnummer: WO9817014

(56) Entgegenhaltungen:
- EP-A- 0 609 964
- GB-A- 2 232 851
- US-A- 5 260 701
- FREYER U.: 'Nachrichtenübertragungstechnik', 1994, HANSER, MONCHEN
- BÜRKLE H.: 'Technik der Telekommunkation, Grundlagen der Funktechnik', R.V. DECKER'S, G.SCHENCK, HEIDELBERG

## Beschreibung

Die Erfindung betrifft eine Datenübertragungsschaltung mit einer Station und mit einer Antwortschaltung, wobei die Station eine Primärspule mit einem Signalgenerator zur Erzeugung eines Magnet-Wechselfeldes mit einer Trägerfrequenz sowie einen Amplituden-Demodulator aufweist, wobei die Antwortschaltung eine Sekundärspule sowie einen Amplituden-Modulator zur Beeinflussung der Last der Sekundärspule aufweist und wobei der Amplituden-Modulator so ausgebildet ist, das das Magnet-Wechselfeld mit einem Datensignal modulierbar ist.

Die gattungsgemäßen Datenübertragungsschaltungen werden insbesondere bei SPR-Systemen (Simultaneous Powering and Reading) mit induktiver Übertragung von Energie und Daten angewendet. Derartige SPR-Systeme kommen auch bei Anwendungen mit kontaktlosen Chipkarten in Einsatz.

Im Betrieb erzeugt der Signalgenerator der Station ein periodisches Signal an der Primärspule, worauf sich in deren Bereich ein induktives Wechselfeld bzw. Magnet-Wechselfeld ausbildet, das im einen Bereich um die Primärspule herum als ein sogenanntes "Nahfeld" wirkt. Im Gegensatz zu einer von der Primärspule ausgehenden elektromagnetischen Welle steht in dem Nahfeld der Primärspule die rein induktive Wirkung des von der Primärspule ausgehenden Signals im Vordergrund.

In den Bereich dieses Nahfeldes ist eine Antwortschaltung einbringbar, die ihre Betriebsenergie insbesondere aus dem Magnet-Wechselfeld bezieht. Dazu ist die Antwortschaltung mit einer Sekundärspule ausgestattet, in der das Magnet-Wechselfeld eine Wechselspannung induziert. Die dort induzierte Wechselspannung wird in der Antwortschaltung gleichgerichtet, geglättet und einem Datensignal-Erzeugungsblock zugeführt. Der Datensignal-Erzeugungsblock steht mit einem insbesondere im Bereich der Sekundärspule angeordneten Amplituden-Modulator derart in Verbindung, daß dieser in Abhängigkeit eines vom Datensignal-Erzeugungsblocks erzeugten Datensignals die Belastung der Sekundärspule ändern kann.

Dazu ist es im Stand der Technik bekannt, den Amplituden-Modulator als veränderliche resistive Last auszubilden, wobei die Widerstands-Belastung der Sekundärspule geeigneterweise entsprechend dem Datensignal verändert wird. Eine derartige Änderung der Widerstands-Belastung der Sekundärspule hat zur Folge, daß sich auch die elektrischen Eigenschaften der Primärspule auf Seiten der Station ändern, da zwischen Primärspule und Sekundärspule eine induktive Koppelung besteht. Der Koppelungsfaktor dieser induktiven Koppelung beträgt in der Regel zwischen einem Prozent und fünf Prozent.

Auf die vorgenannte Weise kann das Magnet-Wechselfeld mit dem Datensignal von der Antwortschaltung moduliert werden, wenn sich die Antwortschaltung im Nahbereich der Primärspule befindet.

Auf der Seite der Primärspule tastet der Amplituden-Demodulator die sich mit dem Datensignal verändernde, an der Primärspule abfallende Spannung ab und rekonstruiert daraus das Datensignal.

Mit der gattungsgemäßen Datenübertragungsschaltung lassen sich Antwortschaltungen auf zuverlässige Weise mit Energie versorgen, wobei weiterhin gewährleistet ist, daß ein von der Antwortschaltung ausgesendetes Datensignal auf der Seite der Station ausgelesen werden kann.

Im praktischen Einsatz der gattungsgemäßen Datenübertragungsschaltungen hat sich jedoch herausgestellt, daß insbesondere bei einer Massenfertigung der Datenübertragungsschaltung häufig Fälle auftreten, in denen das von der Antwortschaltung auf das Magnet-Wechselfeld aufmodulierte Datensignal auf der Seite der Station nicht mehr rekonstruierbar ist. Dies hat insbesondere bei Anwendung der gattungsgemäßen Übertragungsschaltung auf für Kraftfahrzeuge bestimmte Wegfahrsperren dazu geführt, daß ein Benutzer eines Kraftfahrzeuges trotz Autorisierung sein Kraftfahrzeug nicht benutzen kann.

Die GB-A-2 232 851 zeigt einen lose gekoppelten Transformator, über den eine Meßschaltung z.B. auf einem beweglichen Teil eines Fahrzeugs mit Energie versorgt wird. Der Transformator wird durch die Meßelektronik über einen Schalter belastet, und zwar mit einer Frequenz, deren ganzzahliges Vielfaches die Energieversorgungsfrequenz ist. Diese periodische Belastung wird phasenmoduliert, wenn sich der Pegel eines binären Datensignals ändert, das durch die Meßschaltung übertragen wird. Das modulierte Signal wird zurück zu der Primärseite des Transformators transferiert und zur Datengewinnung durch die Multiplikation mit einem periodischen Signal demoduliert.

Es ist Aufgabe der Erfindung, eine Datenübertragungsschaltung der gattungsgemäßen Art bereitzustellen, die stets zuverlässig funktioniert.

Diese Aufgabe wird erfindungsgemäß durch die Maßnahmen der Ansprüche 1, 2, 14u. 15 gelöst.

Die Antwortschaltung weist zusätzlich einen Phasen-Modulator zur Beeinflussung der elektrischen Eigenschaften der Sekundärspule auf, wobei der Amplituden-Modulator und/oder der Phasen-Modulator so ausgebildet sind, daß dieser bzw. diese insbesondere durch wenigstens ein Modulationssignal ansteuerbar ausgebildet sind.

Der Gegenstand der Erfindung beruht auf der erfindungswesentlichen Erkenntnis, daß insbesondere bei einer Massenfertigung einer Antwortschaltung aufgrund der Fertigungstoleranzen der Primärkreis mit der Primärspule und der Sekundärkreis mit der Sekundärspule verstimmt sein können. Bei bestimmten, insbesondere vom Abstand zwischen Sekundärspule und Primärspule abhängigen Koppelfaktoren führt dies dazu, daß die Empfangsspannung in der Primärspule nicht mehr entsprechend einer reinen Amplitudenmodulation moduliert wird. Vielmehr wird die Empfangsspannung in der Primärspule bei bestimmten Bedingungen gemäß einer Phasenmodulation moduliert. Da auf der Seite der Station nur ein Amplituden-Demodulator vorgesehen ist, kann dieser das phasenmodulierte Signal nicht mehr demodulieren, was sich als sogenannte Nullstelle bei der Demodulation des empfangenen Signals äußert.

Durch die Ausbildung der Antwortschaltung gemäß Hauptanspruch 1 wird erreicht, daß das Magnet-Wechselfeld sowohl einer Amplitudenmodulation als auch einer Phasenmodulation unterziehbar ist. Dabei kann durch geeignetes Aktivieren bzw. Deaktivieren des Amplituden-Modulators und/oder des Phasen-Modulators erreicht werden, daß die beiden Modulationen beispielsweise hinsichtlich des Modulationssignals um 90° versetzt sind. Wenn die beiden Modulationen dann hinsichtlich der Stärke geeignet ausgeführt werden, so daß sie hinsichtlich der Amplitude näherungsweise gleiche Seitenbänder erzeugen, dann wird bei geeigneter Versetzung von Amplituden- und Phasenmodulation eine Auslöschung eines Seitenbandes der Modulation erhalten. Dadurch werden hinsichtlich der Amplitudenmodulation unabhängig von Fertigungstoleranzen und variierenden Abständen von Antwortschaltung und Station sogenannte "Modulations-Nullstellen" vermieden. Darüber hinaus kann sowohl ein Amplitudenmodulator als auch - gemäß Anspruch 2 - ein Phasendemodulator das Signal jederzeit demodulieren, da die erfindungsgemäße Modulation des Magnet-Wechselfeldes lediglich zu Phasenunterschieden des empfangenden Datensignals führt, die bei geeigneter Kodierung des Datensignals nicht stören.

Dabei reicht es gemäß dem Grundgedanken der Erfindung bereits aus, wenn die Phasen-Modulation und die Amplituden-Modulation auf Seiten der Antwortschaltung so ausgeführt wird, daß ein Seitenband des Magnet-Wechselfeldes gegenüber dem anderen Seitenband abgeschwächt wird. Schon durch diese Maßnahme wird nämlich der erfindungsgemäße Vorteil erreicht, gemäß dem auf Seiten der Station lediglich ein Amplituden-Demodulator bzw. lediglich ein Phasen-Demodulator ausreicht, um das mit dem Trägersignal modulierte Datensignal zu demodulieren.

Erfindungsgemäß ist der Amplituden-Modulator als parallel zur Sekundärspule zuschaltbarer Widerstand ausgebildet.

Der Phasen-Modulator kann gemäß der Erfindung als parallel zur Sekundärspule zuschaltbarer Kondensator ausgebildet sein, wobei der Kondensator die Funktion eines Phasenschieber-Kondensators hat.

Die Erfindung ist ferner in einer Weiterbildung der Antwortschaltung mit einer Zwischenmodulationsvorrichtung zum Modulieren des Datensignals mit einem Hilfsträgersignal versehen, wobei die Frequenz des Hilfsträgersignals insbesondere verschieden von der Frequenz des Trägersignals bzw. des Magnet-Wechselfeldes ist. Das Hilfsträgersignal ist vorteilhafterweise aus dem Trägersignal gewinnbar, und zwar durch Anwendung eines Frequenzteilers in einer Taktableitungs-Einrichtung. Der Systemtakt dient dann indirekt zur Ansteuerung des Phasen- und/oder Amplituden-Modulators. Das Hilfsträgersignal kann jedoch auch auf andere Weise erzeugt werden.

Gemäß der Erfindung wird das Modulationsergebnis aus Datensignal und Hilfsträgersignal danach mit dem Magnet-Wechselfeld moduliert. Dadurch ergibt sich ein besonders einfacher Aufbau des Amplituden-Demodulators, da sich das Modulationsergebnis besonders einfach demodulieren läßt.

Die Antwortschaltung kann dabei eine Phasenschiebe-Einrichtung aufweisen, die so ausgebildet sein kann, daß wenigstens ein erster und wenigstens ein zweiter jeweils zueinander um einen bestimmten Phasenbetrag verschobene Steuertakte aus dem Systemtakt erzeugbar sind. Dabei ist die Phasenschiebe-Einrichtung mit insbesondere wenigstens einen Frequenzteiler ausgestattet. Dadurch werden ohne nennenswerten Aufwand genau um 90° verschobene Steuertakte aus der Trägersignal-Schwingung des Magnet-Wechselfeldes erzeugt, die direkt zur Ansteuerung von Amplituden- und Phasenmodulator eingesetzt werden können. Diese aus dem Trägersignal abgeleiteten, phasenverschobenen Schwingungen können als Hilfsträgersignale verwendet werden, auf die das Datensignal aufmoduliert wird.

Der Amplituden-Demodulator weist eingangsseitig insbesondere ein Bandpassfilter auf, dessen Mittenfrequenz im wesentlichen gleich der Summe oder der Differenz der Frequenzen von Trägersignal und Hilfssignal ist.

Ein besonders einfacher Aufbau der erfindungsgemäßen Datenübertragungsschaltung ergibt sich dann, wenn die Antwortschaltung und/oder die Station so ausgebildet sind, daß sie digitale Signale verarbeiten können. Derartige Schaltungen lassen sich mit herkömmlicher digitaler Schaltungstechnik auf besonders einfache Weise ausbilden.

Die Erfindung betrifft weiterhin eine Antwortschaltung, die insbesondere zur Verwendung bei einem Transponder oder bei einer Chipkarte bestimmt ist, wobei die Antwortschaltung mit einer Sekundärspule sowie mit einem Amplituden-Modulator zur Beeinflussung der Widerstands-Last der Sekundärspule versehen ist. Dabei ist der Amplituden-Modulator so ausgebildet, daß ein externes Magnet-Wechselfeld mit einem insbesondere von der Antwortschaltung erzeugten Datensignal modulierbar ist, wenn sich die Antwortschaltung im Nahbereich derjenigen Primärspule befindet, die das externe Magnet-Wechselfeld erzeugt.

Gemäß der Erfindung weist die Antwortschaltung dabei zusätzlich einen Phasen-Modulator zur Beeinflussung der elektrischen Eigenschaften der Sekundärspule auf, wobei der Amplituden-Modulator und/oder der Phasen-Modulator so ausgebildet sind, daß dieser bzw. diese durch ein Aktivierungssignal ansteuerbar sind. Die Antwortschaltung kann dabei insbesondere nach einem der Ansprüche 3 bis 13 weitergebildet werden, wodurch sich vorteilhafte Ausgestaltungen der Antwortschaltung gemäß der Erfindung ergeben.

Die Erfindung betrifft auch ein Verfahren zum Modulieren eines externen Magnet-Wechselfelds einer Station mit einem von einer Antwortschaltung aufgrund eines Datensignal erzeugten Modulationssignals. Gemäß der Erfindung erfolgt das Modulieren derart, daß ein Seitenband des modulierten Magnet-Wechselfeldes stärker erzeugt wird als das andere. Dadurch wird die Signalleistung der Modulation des Magnet-Wechselfeldes auf einem Seitenbandkanal konzentriert und Modulations-Nullstellen entfallen.

Vorteilhafte Weiterbildungen des erfindungsgemäßen Verfahrens ergeben sich aus den Unteransprüchen 16 bis 21.

Die Erfindung ist anhand eines Ausführungsbeispiels in der Zeichnung näher erläutert.
- Figur 1: zeigt eine Prinzipskizze einer erfindungsgemäßen Datenübertragungsschaltung mit einer Station und mit einer Anwortschaltung,
- Figur 2: zeigt einen Datensignalerzeugungsblock der Antwortschaltung aus Figur 1,
- Figur 3: zeigt ein Zeigerdiagramm der Modulation eines Magnet-Wechselfeldes der Datenübertragungsschaltung aus Figur 1,
- Figur 4: zeigt ein Zeigerdiagramm der Modulation eines Magnet-Wechselfeldes der Datenübertragungsschaltung aus Figur 1 zu einem Zeitpunkt t=0,
- Figur 5: zeigt ein Zeigerdiagramm der Modulation eines Magnet-Wechselfeldes der Datenübertragungsschaltung aus Figur 1 zu einem Zeitpunkt t=90°, und
- Figur 6: zeigt ein Zeigerdiagramm der Modulation eines Magnet-Wechselfeldes der Datenübertragungsschaltung aus Figur 1 zu einem Zeitpunkt t>90°.

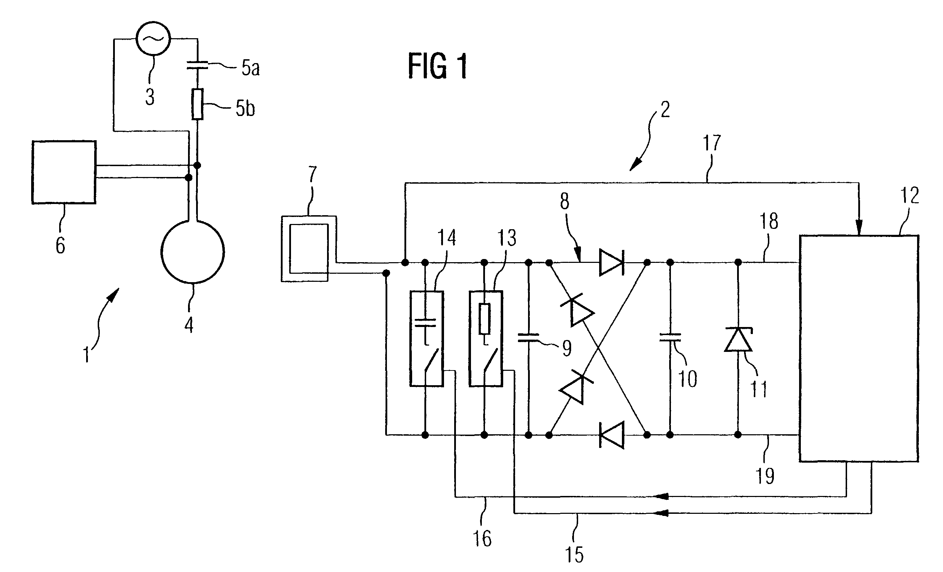

Figur 1 zeigt eine erfindungsgemäße Datenübertragungsschaltung mit einer Station 1 und mit einer Antwortschaltung 2. Die Station 1 weist einen Signalgenerator 3 auf, der in einem Primärkreis ein Wechselspannungssignal mit einer Trägerfrequenz Ω erzeugt. Das vom Signalgenerator 3 erzeugte Wechselspannungssignal wird der Primärspule 4 zugeführt, wobei im Stromkreis zwischen Signalgenerator 3 und Primärspule 4 ein Schwingkreiskondensator 5a sowie ein Dämpfungswiderstand 5b vorgesehen sind. Die Station 1 weist weiterhin einen parallel zur Primärspule 4 geschalteten Demodulator 6 auf. Der Demodulator 6 ist in dieser Ansicht nicht näher dargestellt, er kann sowohl als Amplituden-Demodulator als auch als Phasen-Demodulator ausgeführt sein.

Die Antwortschaltung 2 weist eine Sekundärspule 7 auf, die im Betrieb der erfindungsgemäßen Datenübertragungsschaltung in den Nahbereich der Primärspule 4 gebracht wird. Die Sekundärspule 7 bildet mit einem Schwingkreiskondensator 9 einen Sekundärkreis. Der Schwingkreiskondensator 9 gibt dem Sekundärkreis eine geeignete Resonanzfrequenz. Der sich an die Sekundärspule 7 sowie an den Schwingkreiskondensator 9 anschließende Teil der Antwortschaltung 2 gliedert sich im wesentlichen in eine Energieversorgungs-Baugruppe sowie in eine Trägersignal-Modulationsbaugruppe.

Die Energieversorgungs-Baugruppe weist dazu einen Gleichrichter 8 auf, der an seinem Ausgang mit einem Glättungs- bzw. Siebkondensator 10 versehen ist. Weiterhin hat die Energieversorgungs-Baugruppe einen Spannungsregler in der Form einer Zenerdiode 11. Der Gleichrichter 8 ist in der gezeigten Ausführungsform 2 der Antwortschaltung als Brückengleichrichter aus vier Dioden aufgebaut.

Die Trägersignal-Modulationsbaugruppe besteht im wesentlichen aus einem Datensignalerzeugungsblock 12, einem Amplituden-Modulator 13 sowie aus einem Phasen-Modulator 14. Dabei ist der Amplituden-Modulator 13 parallel zu der Sekundärspule 7 geschaltet, so daß diese mit einem zusätzlichen Widerstand belastbar ist. Demgegenüber hat der Phasen-Modulator 14 einen parallel zur Sekundärspule 7 zuschaltbaren Kondensator, so daß deren kapazitive Belastung veränderbar ist. Der Amplituden-Modulator 13 und der Phasen-Modulator 14 sind sowohl als lineare als auch als nicht-lineare Modulatoren ausführbar.

Im gezeigten Ausführungsbeispiel ist der Amplituden-Modulator als Reihenschaltung eines ohmschen Widerstandes mit einem elektrisch betätigbaren Schalter ausgeführt. Der Phasen-Modulator 14 ist demgegenüber als Reihenschaltung eines Kondensators und eines elektrisch betätigbaren Schalters ausgeführt. Der Amplituden-Modulator 13 und der Phasen-Modulator 14 stehen über je eine Verbindungsleitung 15 bzw. 16 mit dem Datensignalerzeugungsblock 12 in Verbindung, und zwar derart, daß deren Schalter auf Anweisung des Datensignalerzeugungsblocks 12 hin betätigbar sind.

Der Datensignalerzeugungsblock 12 steht weiterhin über eine Trägersignalleitung 17 direkt mit der Sekundärspule 7 in Verbindung. Schließlich weist der Datensignalerzeugungsblock 12 auch Energieversorgungsanschlüsse 18 bzw. 19 auf, mit denen er mit der Energieversorgungsbaugruppe der Antwortschaltung 2 in Verbindung steht.

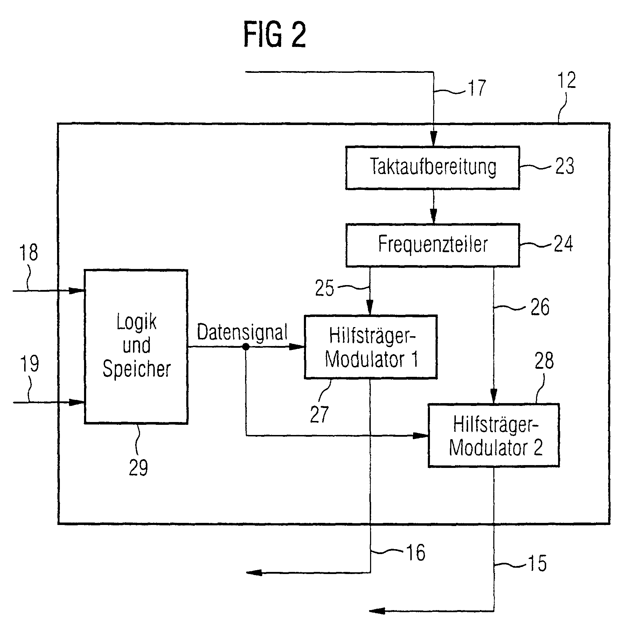

Figur 2 zeigt den Datensignalerzeugungsblock 12 der Antwortschaltung 1 in näherem Detail. Der Datensignalerzeugungsblock 12 hat eine Taktaufbereitungsvorrichtung 23, die über die Trägersignalleitung 17 mit der Sekundärspule 7 in Verbindung steht. An die Taktaufbereitungsvorrichtung 23 schließt sich ein Frequenzteiler 24 an, der darüber hinaus eine in dieser Ansicht nicht gezeigte Phasenschiebeeinrichtung beinhaltet. Der Frequenzteiler 24 erzeugt zwei zueinander phasenverschobene, gleichfrequente Signale, die über eine erste Ausgangsleitung 25 und eine zweite Ausgangsleitung 26 abgegeben werden. Das erste vom Frequenzteiler 24 erzeugte Signal wird über die erste Ausgangsleitung 25 an einen ersten Hilfsträger-Modulator 27 übergeben. Das zweite vom Frequenzteiler 24 erzeugte Signal wird über die zweite Ausgangsleitung 26 an den zweiten Hilfsträger-Modulator 28 übergeben. Zur Ausgabe der Signale vom ersten Hilfsträger-Modulator 27 und vom zweiten Hilfsträger-Modulator 28 sind diese an die bereits zuvor erwähnten Verbindungsleitungen 15 bzw. 16 angeschlossen.

Der erste Hilfsträger-Modulator 27 und der zweite Hilfsträger-Modulator 28 empfangen darüber hinaus von einer weiterhin im Datensignalerzeugungsblock 12 vorgesehenen Logik- und Speichereinrichtung 29 ein Datensignal. Die Logik- und Speichereinrichtung 29 bezieht genau wie alle anderen Baugruppen des Datensignalerzeugungsblocks 12 ihre Betriebsenergie von den Energieversorgungsanschlüssen 18 und 19. Der erste Hilfsträger-Modulator 27 und der zweite Hilfsträger-Modulator 28 sind so ausgebildet, daß die vom Frequenzteiler 24 erzeugten Signale mit dem Datensignal von der Logik- und Speichereinrichtung 29 moduliert werden können.

Im Betrieb verhält sich die Datenübertragungsschaltung gemäß der Erfindung wie nachfolgend beschrieben.

Der Signalgenerator 3 in der Station 1 erzeugt ein hochfrequentes Wechselspannungssignal, das der Primärspule 4 zugeführt wird. Dabei führt der Schwingkreiskondensator 5a aufgrund einer Serienresonanz zu einer Erhöhung der Spannung in der Primärspule 4. Der Dämpfungswiderstand 5b sorgt für die nötige Bandbreite. Die an den beiden Anschlüssen des Signalgenerators 3 angeschlossene Primärspule 4 wird demzufolge mit dem vom Signalgenerator 3 erzeugten Wechselspannungssignal mit einer Trägerfrequenz Ω beaufschlagt. Dadurch bildet sich im Bereich der Primärspule 4 ein induktives Magnet-Wechselfeld aus, das im Bereich um die Primärspule 4 als ein sogenanntes Nahfeld wirkt. Dabei ändert sich die magnetische Feldstärke des Magnet-Wechselfeldes mit der Trägerfrequenz Ω.

Im Betrieb der erfindungsgemäßen Datenübertragungsschaltung wird die Antwortschaltung 2 in den Bereich des Nahfeldes des Primärspule 4 eingebracht, und zwar derart, daß sich die Sekundärspule 7 der Antwortschaltung 2 in der unmittelbaren Umgebung der Primärspule 4 befindet. Dann induziert das Magnet-Wechselfeld in der Sekundärspule eine Wechselspannung mit einer Frequenz, die mit der Trägerfrequenz Ω übereinstimmt. Diese Wechselspannung wird von der Energieversorgungs-Baugruppe der Antwortschaltung 2 abgetastet und gleichgerichtet. Dazu ist der Gleichrichter 8 mit den beiden Ausgängen der Sekundärspule 7 verbunden. Am Ausgang des Gleichrichters 8 tritt aufgrund der Wirkung des Glättungs-bzw. Siebkondensators 10 dann eine geglättete Gleichspannung auf, deren Größe von der Zenerdiode 11 begrenzt wird, und zwar auf einen Wert, der für den Betrieb des Datensignalerzeugungsblock 12 notwendig ist. Die geglättete und begrenzte Ausgangsspannung der Energieversorgungs-Baugruppe wird über die Energieversorgungsanschlüsse 18 und 19 am Datensignalerzeugungsblock 12 angelegt.

Daraufhin begibt sich der Datensignalerzeugungsblock 12 in einen aktiven Zustand, in dem er über die Trägersignalleitung 17 die in der Sekundärspule 7 induzierte Spannung abtastet. Die in Figur 2 gezeigte Taktableitungsvorrichtung 20 leitet aus der in der Sekundärspule 7 induzierten Wechselspannung einen Systemtakt ab und führt diesen dem Frequenzteiler 21 zu.

Im Frequenzteiler 21 ist eine in dieser Ansicht nicht dargestellte Phasenschiebe-Einrichtung vorgesehen, die aus dem Systemtakt ein erstes Hilfsträgersignal sowie ein mit dem ersten Hilfsträgersignal gleichfrequentes zweites Hilfsträgersignal erzeugt, das bezüglich der Phase des ersten Hilfsträgersignals um 90° zum ersten Hilfsträgersignal verschoben ist.

In den in Figur 2 dargestellten Hilfsträger-Modulatoren 24, 25 wird das im Logik- und Speicherblock 26 gespeicherte Datensignal mit den Hilfsträgersignalen zu einem Phasenmodulationssignal und zu einem Amplitudenmodulationssignal moduliert. Das Amplitudenmodulationssignal wird daraufhin über die Verbindungsleitung 15 dem Amplituden-Modulator 13 zugeführt, während das Phasenmodulationssignal über die Verbindungsleitung 16 dem Phasen-Modulator 14 zugeführt wird.

Der Amplituden-Modulator 13 und der Phasen-Modulator 14 belasten die Sekundärspule 7 entsprechend den ihnen zugeführten Signalen. Da zwischen Primärspule 4 und Sekundärspule 7 eine Koppelung besteht, wirkt die Belastung der Sekundärspule 7 durch den Phasen-Modulator 14 und durch den Amplituden-Modulator 13 auf die elektrischen Eigenschaften der Primärspule 4 zurück. Dadurch verändert sich Form und Größe des sich an der Primärspule 4 ergebenden Signals, was vom Demodulator 6 abgetastet wird. Bei geeigneter Ausbildung des in dieser Ansicht nicht näher gezeigten Demodulators 6 läßt sich das Datensignal aus der so veränderten Wechselspannung in der Primärspule 4 rekonstruieren.

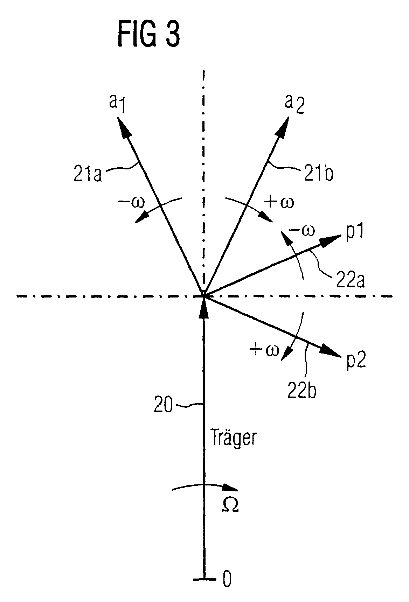

Die Figuren 3 bis 6 veranschaulichen die Funktionsweise der erfindungsgemäßen Modulation des Trägersignals mit dem Hilfsträgersignal, wobei diese Darstellungen auf die vom Datensignal nicht beeinflußten Hilfsträgersignale bzw. Phasen- und Amplitudenmodulationssignale beschränkt sind, um den Grundgedanken der Erfindung anschaulicher zu machen.

Figur 3 zeigt eine Zeigerdarstellung einer Modulation der Hilfsträgersignale mit dem Trägersignal, wie sie durch den Amplituden-Modulator 13 und durch den Phasen-Modulator 14 ausgeführt wird. Das Trägersignal ist dabei als Trägersignal-Zeiger 20 dargestellt, der mit seiner Trägerfrequenz Ω um den Ursprung O rotiert. Um die Spitze des Trägersignal-Zeigers 20 rotierend dargestellt sind die Amplitudenmodulationssignal-Zeiger 21a (a₁) und 21b (a₂) sowie die Phasenmodulationssignal-Zeiger 22a (p₁) und 22b (p₂). Sowohl für die Amplitudenmodulation des Datensignals als auch für die Phasenmodulation des Trägersignals sind dabei je zwei Zeiger 21a, 21b bzw. 22a, 22b dargestellt, die jeweils die beiden Spektralanteile der Amplitudenmodulation und der Phasenmodulation wiedergeben. Die Hilfsträgersignale bzw.

Phasen- und Amplitudenmodulationssignale weisen eine konstante Frequenz ω auf. Die Rotationsgeschwindigkeit ω der Spektralanteile gegenüber dem Trägersignal entspricht der Frequenz des Hilfsträgersignals, die für alle Zeiger 21a, 21b, 22a, 22b der Amplitudenmodulation und der Phasenmodulation gleich ist. Die Zeiger 21a und 22a der Amplitudenmodulation bzw. der Phasenmodulation rotieren jedoch entgegengesetzt zu den Zeigern 21b bzw. 22b der Amplitudenmodulation bzw. der Phasenmodulation.

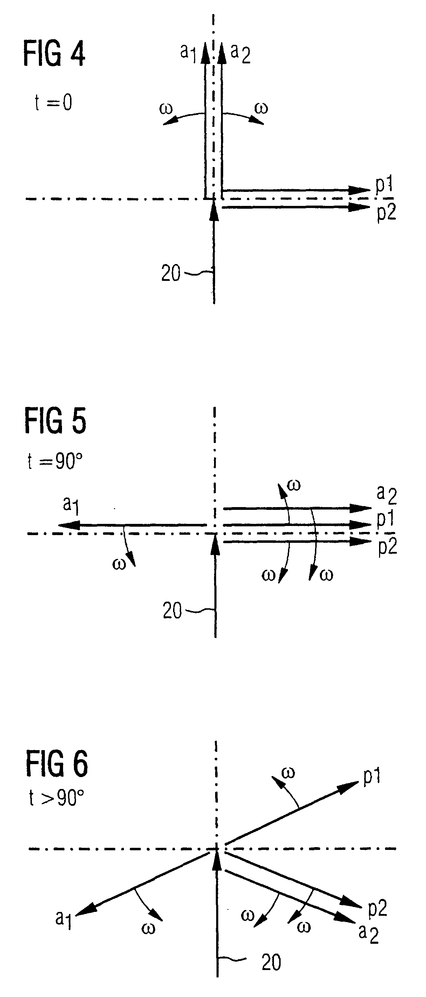

Figur 4 zeigt das Zeigerdiagramm aus Figur 3 zu einem Zeitpunkt t=0. Der Trägersignal-Zeiger 20 rotiert mit der Trägerfrequenz Ω, während die Amplitudenmodulations-Zeiger a₁, a₂, sowie die Phasenmodulations-Zeiger p₁, p₂ ruhen.

Zum Zeitpunkt t=0 wird die Amplitudenmodulation in Gang gesetzt. Demzufolge beginnen die Amplitudenmodulations-Zeiger a₁, a₂ mit der Rotationsgeschwindigkeit ω um die Spitze des Trägersignal-Zeigers 20 zu rotieren, wobei der eine Spektralanteil a₁ in der gezeigten Darstellung gegen den Uhrzeigersinn rotiert, während der andere Spektralanteil a₂ mit dem Uhrzeigersinn rotiert.

Figur 5 zeigt das Zeigerdiagramm der Modulation des Magnet-Wechselfeldes der Datenübertragungsschaltung zum Zeitpunkt t=90°/ω. Zu diesem Zeitpunkt haben sich die Spektralanteile a₁, a₂ der Amplitudenmodulation aus der in Figur 4 dargestellten senkrechten Lage in eine waagrechte Lage bewegt, so daß der eine Spektralanteil a₂ der Amplitudenmodulation mit den beiden Spektralanteilen p₁, p₂ der Phasenmodulation zusammenfällt, während der andere Spektralanteil a₁ der Amplitudenmodulation den Spektralanteilen a₂, p₁, p₂ gegenüberliegt. Genau in diesem Zeitpunkt setzen sich die Spektralanteile p₁, p₂ der Phasenmodulation in Gang. Der eine Spektralanteil p₁ beginnt dann, sich mit der Frequenz ω gegen den Uhrzeigersinn zu drehen, während der andere Spektralanteil p₂ beginnt, sich mit der Frequenz ω mit dem Uhrzeigersinn zu drehen. Wie man in dieser Darstellung deutlich sieht, löschen sich - gleiche Amplituden der Spektralanteile a₁ und p₁ vorausgesetzt - der Spektralanteil a₁ mit dem Spektralanteil p₁ aus. Die verbleibenden Spektralanteile a₂ und der andere Spektralanteil p₂ der Phasenmodulation verstärken sich.

Figur 6 zeigt das Zeigerdiagramm aus Figur 3 zum Zeitpunkt t>90°/ω. Zu diesem Zeitpunkt haben sich die Spektralanteile a₁, a₂ der Amplitudenmodulation aus der Lage in Figur 5 um einen bestimmten Winkel weiterbewegt. Die Spektralanteile p₁, p₂ haben sich aus der Lage in Figur 5 ebenfalls um einen bestimmten Winkel weiterbewegt. Die Winkel, um die sich die Spektralanteile a₁, a₂, bzw. p₁, p₂ aus der Lage in Figur 5 weiterbewegt haben, stimmen jeweils überein, da sich die Spektralanteile jeweils mit der gleichen Frequenz ω um die Spitze des Trägersignal-Zeigers 20 drehen. Wie man in dieser Darstellung besonders gut sieht, löschen sich der Spektralanteil a₁ der Amplitudenmodulation und der Spektralanteil p₁ der Phasenmodulation aus, während sich die Spektralanteile a₂ der Amplitudenmodulation und p₂ der Phasenmodulation verstärken.

Bei der erfindungsgemäßen Antwortschaltung eilt z.B. die Phasenmodulation somit der Amplitudenmodulation um 90° der Signalperiode der Frequenz ω des Hilfsträgersignals voraus. Es ist jedoch auch denkbar, daß die Phasenmodulation somit der Amplitudenmodulation um 90° der Signalperiode der Frequenz ω des Hilfsträgersignals nacheilt. Im ersten Fall fallen die Richtungen der Zeiger 21b und 22b stets zusammen, während die Richtungen der Zeiger 21a und 22a stets entgegengesetzt liegen. Modulations-Nullstellen entfällt daher. Falls die Zeiger 21a und 22a die gleiche Länge haben, kommt es dann zur vollständigen Auslöschung eines Seitenbandes, so daß die Signalleistung der Modulation des Magnet-Wechselfeldes auf einem Seitenband konzentriert wird.

## Patentansprüche

1. Datenübertragungsschaltung mit einer Station **(1)** und mit einer insbesondere für eine Chipkarte bestimmten Antwortschaltung,
wobei die Station **(1)** eine Primärspule **(4)** mit einem Signalgenerator **(3)** zur Erzeugung eines Magnet-Wechselfeldes mit einer Trägerfrequenz sowie einen Amplituden-Demodulator **(6)** aufweist,
wobei die Antwortschaltung **(2)** eine Sekundärspule **(7)** sowie einen Amplituden-Modulator **(13)** zur Beeinflussung der Last der Sekundärspule **(7)** aufweist, wobei der Amplituden-Modulator **(13)** so ausgebildet ist, daß das Magnet-Wechselfeld mit einem Datensignal modulierbar ist,
**dadurch gekennzeichnet, daß** die Antwortschaltung (2) einen Phasen-Modulator (14) zur Beeinflussung der elektrischen Eigenschaften der Sekundärspule (7) aufweist, wobei der Amplituden-Modulator (13) und/oder der Phasen-Modulator (14) jeweils durch mindestens ein Modulationssignal so ansteuerbar ausgebildet sind,
daß ein Seitenband des Magnet-Wechselfelds stärker erzeugbar ist als das andere.

2. Datenübertragungsschaltung mit einer Station **(1)** und mit einer insbesondere für eine Chipkarte bestimmten Antwortschaltung,
wobei die Station eine Primärspule **(4)** mit einem Signalgenerator **(3)** zur Erzeugung eines Magnet-Wechselfeldes sowie einen Demodulator **(6)** aufweist,
wobei die Antwortschaltung eine Sekundärspule **(7)** sowie einen Amplituden-Modulator **(13)** zur Beeinflussung der elektrischen Eigenschaften der Sekundärspule **(7)** aufweist, wobei der Amplituden-Modulator **(13)** so ausgebildet ist, daß das Magnet-Wechselfeld mit einem Datensignal modulierbar ist,
**dadurch gekennzeichnet, daß** die Antwortschaltung (2) einen Phasen-Modulator **(14)** zur Beeinflussung der elektrischen Eigenschaften der Sekundärspule (7) aufweist, wobei der Amplituden-Modulator (13) und/oder der Phasen-Modulator (14) jeweils durch mindestens ein Modulationssignal so ansteuerbar ausgebildet sind, daß ein Seitenband des Magnet-Wechselfelds stärker erzeugbar ist als das andere,
und dadurch, daß der Demodulator (6) als Phasen-Demodulator ausgebildet ist.

3. Datenübertragungsschaltung nach Anspruch 1 oder Anspruch 2, **dadurch gekennzeichnet, daß** die Antwortschaltung (2) derart ausgebildet ist, daß der Amplituden-Modulator (13) und/oder der Phasen-Modulator (14) derart ansteuerbar sind, daß die Phasenmodulation gegenüber der Amplitudenmodulation bezüglich deren Phase versetzt ist.

4. Datenübertragungsschaltung nach Anspruch 3, **dadurch gekennzeichnet, daß** die Antwortschaltung (2) derart ausgebildet ist, daß der Amplituden-Modulator (13) und/oder der Phasen-Modulator (14) so ansteuerbar sind, daß die Phasenmodulation gegenüber der Amplitudenmodulation hinsichtlich der Signalperiode des Modulationssignals um 90° voreilt bzw. nacheilt.

5. Datenübertragungsschaltung nach einem der vorhergehenden Ansprüche, **dadurch gekennzeichnet, daß** der Amplituden-Modulator (13) als parallel zur Sekundärspule (7) zuschaltbarer Widerstand ausgebildet ist.

6. Datenübertragungsschaltung nach einem der vorhergehenden Ansprüche, **dadurch gekennzeichnet, daß** der Phasen-Modulator (14) als parallel zur Sekundärspule (7) zuschaltbarer Kondensator ausgebildet ist.

7. Datenübertragungsschaltung nach einem der vorhergehenden Ansprüche, **dadurch gekennzeichnet, daß** die Antwortschaltung wenigstens eine Zwischenmodulationsvorrichtung (24, 25) zur Modulation des Datensignals mit einem Hilfsträgersignal aufweist.

8. Datenübertragungsschaltung nach einem der vorhergehenden Ansprüche, **dadurch gekennzeichnet, daß** die Antwortschaltung (2) eine Taktableitungs-Einrichtung **(23, 24)** zur Ableitung eines Hilfsträgersignals aus dem Magnet-Wechselfeld aufweist.

9. Datenübertragungsschaltung nach einem der vorhergehenden Ansprüche, **dadurch gekennzeichnet, daß** die Antwortschaltung (2) eine Phasenschiebe-Einrichtung **(24)** aufweist, die so ausgebildet ist, daß wenigstens ein erstes und wenigstens ein zweites jeweils zueinander um einen bestimmten Phasenbetrag verschobenes Hilfsträgersignal aus dem Systemtakt erzeugbar sind.

10. Datenübertragungsschaltung nach einem der vorhergehenden Ansprüche, **dadurch gekennzeichnet, daß** die Phasenschiebe-Einrichtung mindestens einen Frequenzteiler **(24)** aufweist.

11. Datenübertragungsschaltung nach einem der vorhergehenden Ansprüche, **dadurch gekennzeichnet, daß** der Demodulator (6) eingangsseitig ein Bandpaßfilter aufweist.

12. Datenübertragungsschaltung nach Anspruch 10 sowie nach Anspruch 11, **dadurch gekennzeichnet, daß** die Mittenfrequenz des Bandpaßfilters im wesentlichen gleich der Summe oder der Differenz der Frequenzen von Trägersignal und Hilfsträgersignal ist.

13. Datenübertragungsschaltung nach einem der vorhergehenden Ansprüche, **dadurch gekennzeichnet, daß** die Antwortschaltung und/oder die Station als zur Verarbeitung von digitalen Signalen bestimmte Schaltungen ausgebildet sind.

14. Antwortschaltung (2), insbesondere zur Verwendung bei einem Transponder oder bei einer Chipkarte, mit einer Sekundärspule **(7)** , die vorgesehen ist, um mit einer Primärspule einer Station (1) in induktiver Wechselwirkung zu stehen, sowie mit einen Amplituden-Modulator **(13)** zur Beeinflussung der elektrischen Eigenschaften der Sekundärspule **(7)**, wobei der Amplituden-Modulator **(13)** so ausgebildet ist, daß ein externes Magnet-Wechselfeld mit einem Datensignal modulierbar ist,
**dadurch gekennzeichnet, daß** die Antwortschaltung 82) einen Phasen-Modulator (14) zur Beeinflussung der elektrischen Eigenschaften der Sekundärspule (7) aufweist, wobei der Amplituden-Modulator (13) und/oder der Phasen-Modulator (14) jeweils durch mindestens ein Modulationssignal so ansteuerbar sind, daß ein Seitenband des Magnet-Wechselfelds stärker erzeugbar ist als das andere.

15. Verfahren zum Modulieren eines externen Magnet-Wechselfeldes einer Station **(1)** die eine Primärspule aufweist, mit einem von einer Sekundärspule einer Antwortschaltung **(2)** aufgrund eines Datensignals erzeugten Modulationssignals, wobei die Primärspule mit der Sekundärspule in induktiver Wechselwirkung gebracht ist,
**dadurch gekennzeichnet, daß** das Modulieren derart erfolgt, daß ein Seitenband des modulierten Magnet-Wechselfeldes stärker erzeugt wird als das andere.

16. Verfahren nach Anspruch 15, **dadurch gekennzeichnet, daß** das Modulieren des Magnet-Wechselfeldes sowohl mit einer Amplitudenmodulation als auch mit einer Phasenmodulation erfolgt.

17. Verfahren nach Anspruch 16, **dadurch gekennzeichnet, daß** die Amplitudenmodulation gegenüber der Phasenmodulation mit einer Phasenverschiebung erfolgt.

18. Verfahren nach Anspruch 17, daß die Phasenverschiebung 90° beträgt, und zwar entweder vorauseilend oder nacheilend.

19. Verfahren nach einem der Ansprüche 15 bis 18, **dadurch gekennzeichnet, daß** die Amplitudenmodulation mit einem durch ein Amplitudenmodulationssignal angesteuerten Amplituden-Modulator (13) erfolgt und daß die Phasenmodulation mit einem durch ein Phasenmodulationssignal angesteuerten Phasen-Modulator (14) erfolgt, wobei das Amplitudenmodulationssignal und/oder das Phasenmodulationssignal jeweils aus einer Modulation des Datensignals mit je einem Hilfsträgersignal erzeugt werden.

20. Verfahren nach Anspruch 19, **dadurch gekennzeichnet, daß** das Hilfsträgersignal bzw. die Hilfsträgersignale durch Frequenzteilung aus dem Magnet-Wechselfeld abgeleitet werden.

21. Verfahren nach Anspruch 19 oder Anspruch 20, **dadurch gekennzeichnet, daß** die Hilfsträgersignale so erzeugt werden, daß zwischen ihnen eine Phasenverschiebung von insbesondere 90° besteht.

## Claims

1. Data transmission circuit having a station (1) and having a response circuit which is intended in particular for a smart card, the station (1) having an amplitude demodulator (6) as well as a primary coil (4) with a signal generator (3) for producing an alternating magnetic field at a carrier frequency, the response circuit (2) having a secondary coil (7) as well as an amplitude modulator (13) for influencing the load on the secondary coil (7), and the amplitude modulator (13) being designed such that the alternating magnetic field can be modulated with a data signal,
**characterized in that** the response circuit (2) has a phase modulator (14) for influencing the electrical characteristics of the secondary coil (7), the amplitude modulator (13) and/or the phase modulator (14) each being designed such that they/it can be driven by at least one modulation signal in such a manner that one sideband of the alternating magnetic field can be produced to be stronger than the other.

2. Data transmission circuit having a station (1) and having a response circuit which is intended in particular for a smart card, the station having a demodulator (6) as well as a primary coil (4) with a signal generator (3) for producing an alternating magnetic field, the response circuit having a secondary coil (7) as well as an amplitude modulator (13) for influencing the electrical characteristics of the secondary coil (7), and the amplitude modulator (13) being designed such that the alternating magnetic field can be modulated with a data signal,
**characterized in that** the response circuit (2) has a phase modulator (14) for influencing the electrical characteristics of the secondary coil (7), the amplitude modulator (13) and/or the phase modulator (14) each being designed such that they/it can be driven by at least one modulation signal in such a manner that one sideband of the alternating magnetic field can be produced to be stronger than the other, and **in that** the demodulator (6) is designed as a phase demodulator.

3. Data transmission circuit according to Claim 1 or Claim 2, **characterized in that** the response circuit (2) is designed in such a manner that the amplitude modulator (13) and/or the phase modulator (14) can be driven in such a manner that the phase modulation is offset with respect to the phase of the amplitude modulation.

4. Data transmission circuit according to Claim 3, **characterized in that** the response circuit (2) is designed in such a manner that the amplitude modulator (13) and/or the phase modulator (14) can be driven such that the phase modulation leads or lags the amplitude modulation by 90° with respect to the signal period of the modulation signal.

5. Data transmission circuit according to one of the preceding claims, **characterized in that** the amplitude modulator (13) is designed as a resistor which can be connected in parallel with the secondary coil (7).

6. Data transmission circuit according to one of the preceding claims, **characterized in that** the phase modulator (14) is designed as a capacitor which can be connected in parallel with the secondary coil (7).

7. Data transmission circuit according to one of the preceding claims, **characterized in that** the response circuit has at least one intermediate modulation modulation apparatus (24, 25) for modulation of the data signal with an auxiliary carrier signal.

8. Data transmission circuit according to one of the preceding claims, **characterized in that** the response circuit (2) has a clock derivation device (23, 24) for deriving an auxiliary carrier signal from the alternating magnetic field.

9. Data transmission circuit according to one of the preceding claims, **characterized in that** the response circuit (2) has a phase-shifting device (24), which is designed such that at least a first auxiliary carrier signal and at least a second auxiliary carrier signal can be produced from the system clock, which auxiliary carrier signals are each phase-shifted by a specific amount with respect to one another.

10. Data transmission circuit according to one of the preceding claims, **characterized in that** the phase-shifting device has at least one frequency divider (24).

11. Data transmission circuit according to one of the preceding claims, **characterized in that** the demodulator (6) has a bandpass filter on the input side.

12. Data transmission circuit according to Claim 10, as well as that according to Claim 11, **characterized in that** the mid-frequency of the bandpass filter is essentially equal to the sum or to the difference of the frequencies of the carrier signal and the auxiliary carrier signal.

13. Data transmission circuit according to one of the preceding claims, **characterized in that** the response circuit and/or the station are/is designed as circuits which are intended for processing digital signals.

14. Response circuit (2), in particular for use in a transponder or in a smart card, having a secondary coil (7) which is designed to interact inductively with a primary coil of a station (1) and having an amplitude modulator (13) for influencing the electrical characteristics of the secondary coil (7), the amplitude modulator (13) being designed such that an external alternating magnetic field can be modulated with a data signal, **characterized in that** the response circuit 82) [sic] has a phase modulator (14) for influencing the electrical characteristics of the secondary coil (7), in which case the amplitude modulator (13) and/or the phase modulator (14) can each be driven by at least one modulation signal in such a manner that one sideband of the alternating magnetic field can be produced to be stronger than the other.

15. Method for modulating an external alternating magnetic field of a station (1), said station having a primary coil, with a modulation signal which is produced by a secondary coil of a response circuit (2) on the basis of a data signal, the primary coil being made to interact inductively with the secondary coil, **characterized in that** the modulation is carried out in such a manner that one sideband of the modulated alternating magnetic field is produced more strongly than the other.

16. Method according to Claim 15, **characterized in that** the modulation of the alternating magnetic field is carried out both with amplitude modulation and with phase modulation.

17. Method according to Claim 16, **characterized in that** the amplitude modulation is carried out with a phase shift with respect to the phase modulation.

18. Method according to Claim 17, [lacuna] that the phase shift is 90°, to be precise either leading or lagging.

19. Method according to one of Claims 15 to 18, **characterized in that** the amplitude modulation is carried out using an amplitude modulator (13) which is driven by an amplitude modulation signal, and **in that** the phase modulation is carried out using a phase modulator (14) which is driven by a phase modulation signal, the amplitude modulation signal and/or the phase modulation signal each being produced from modulation of the data signal with in each case one auxiliary carrier signal.

20. Method according to Claim 19, **characterized in that** the auxiliary carrier signal or the auxiliary carrier signals is or are derived by frequency division from the alternating magnetic field.

21. Method according to Claim 19 or Claim 20, **characterized in that** the auxiliary carrier signals are produced such that there is a phase shift of, in particular, 90° between them.

## Revendications

1. Circuit de transmission de données comportant une station (1) et un circuit de réponse, destiné en particulier à une carte à puce,
dans lequel la station (1) comporte une bobine primaire (4) doté d'un générateur de signal (3) pour générer un champ magnétique alternatif ayant une porteuse, ainsi qu'un démodulateur d'amplitude (6),
dans lequel le circuit de réponse (2) comporte une bobine secondaire (7) ainsi qu'un modulateur d'amplitude (13) pour influer sur la charge de la bobine secondaire (7), le modulateur d'amplitude (13) étant conformé de telle sorte que le champ magnétique alternatif peut être modulé par un signal de données,
**caractérisé en ce que** le circuit de réponse (2) comporte un modulateur de phase (14) pour influer sur les propriétés électriques de la bobine secondaire (7), le modulateur d'amplitude (13) et/ou le modulateur de phase (14) étant chacun conformés pour pouvoir être commandés par au moins un signal de modulation de manière à générer une bande latérale du champ magnétique alternatif ayant une amplitude plus grande que celle de l'autre bande latérale.

2. Circuit de transmission de données comportant une station (1) et un circuit de réponse, destiné en particulier à une carte à puce,
dans lequel la station comporte une bobine primaire (4) doté d'un générateur de signal (3) pour générer un champ magnétique alternatif, ainsi qu'un démodulateur (6),
dans lequel le circuit de réponse comporte une bobine secondaire (7) ainsi qu'un modulateur d'amplitude (13) pour influer sur les propriétés électriques de la bobine secondaire (7), le modulateur d'amplitude (13) étant conformé de manière à pouvoir moduler le champ magnétique alternatif par un signal de données,
**caractérisé en ce que** le circuit de réponse (2) comporte un modulateur de phase (14) pour influer sur les propriétés électriques de la bobine secondaire (7), le modulateur d'amplitude (13) et/ou le modulateur de phase (14) étant chacun conformés de façon à pouvoir être commandés par au moins un signal de modulation de manière à pouvoir générer une bande latérale du champ magnétique alternatif ayant une amplitude plus grande que celle de l'autre bande latérale,
et **en ce que** le démodulateur (6) est conformé en démodulateur de phase.

3. Circuit de transmission de données selon la revendication 1 ou la revendication 2, **caractérisé en ce que** le circuit de réponse (2) est conformé de manière à pouvoir commander le modulateur d'amplitude (13) et/ou le modulateur de phase (14) de telle sorte que la modulation de phase soit déphasée par rapport à la modulation d'amplitude.

4. Circuit de transmission de données selon la revendication 3, **caractérisé en ce que** le circuit de réponse (2) est conformé de manière à pouvoir commander le modulateur d'amplitude (13) et/ou le modulateur de phase (14) de telle sorte que la modulation de phase soit en avance ou en retard de phase de 90° par rapport à la modulation d'amplitude quant à la période du signal de modulation.

5. Circuit de transmission de données selon l'une des revendications précédentes, **caractérisé en ce que** le modulateur d'amplitude (13) se présente sous la forme d'une résistance qui peut être montée en parallèle sur la bobine secondaire (7).

6. Circuit de transmission de données selon l'une des revendications précédentes, **caractérisé en ce que** le modulateur de phase (11) se présente sous la forme d'un condensateur qui peut être monté en parallèle sur la bobine secondaire (7).

7. Circuit de transmission de données selon l'une des revendications précédentes, **caractérisé en ce que** le circuit de réponse comporte au moins un dispositif de modulation intermédiaire (24, 25) pour moduler le signal de données par une porteuse auxiliaire.

8. Circuit de transmission de données selon l'une des revendications précédentes, **caractérisé en ce que** le circuit de réponse (2) comporte un dispositif de dérivation de signal d'horloge (23, 24) pour dériver une porteuse auxiliaire à partir du champ magnétique alternatif.

9. Circuit de transmission de données selon l'une des revendications précédentes, **caractérisé en ce que** le circuit de réponse (2) comporte un dispositif de déphasage (24) qui est conformé de façon à pouvoir générer au moins un premier signal auxiliaire et au moins un deuxième signal auxiliaire, déphasés d'une valeur déterminée, à partir du signal d'horloge du système.

10. Circuit de transmission de données selon l'une des revendications précédentes, **caractérisé en ce que** le dispositif de déphasage comporte au moins un diviseur de fréquence (24).

11. Circuit de transmission de données selon l'une des revendications précédentes, **caractérisé en ce que** le démodulateur (6) comporte en entrée un filtre passe-bande.

12. Circuit de transmission de données selon la revendication 10 et la revendication 11, **caractérisé en ce que** la fréquence médiane du filtre passe-bande est sensiblement égale à la somme ou la différence de la fréquence de la porteuse et de la fréquence de la porteuse auxiliaire.

13. Circuit de transmission auxiliaire selon l'une des revendications précédentes, **caractérisé en ce que** le circuit de réponse et/ou la station sont conformés en circuits destinés à traiter des signaux numériques.

14. Circuit de réponse (2), destiné en particulier à être utilisé dans un transpondeur ou une carte à puce, comportant une bobine secondaire (7), qui est prévue pour coopérer par induction avec une bobine primaire d'une station (1), ainsi qu'un modulateur de phase (13) destiné à influer sur les propriétés électriques de la bobine secondaire (7), le modulateur d'amplitude (13) étant conformé de telle sorte qu'un champ magnétique alternatif externe peut être modulé par un signal de données, **caractérisé en ce que** le circuit de réponse (2) comporte un modulateur de phase (14) destiné à influer sur les propriétés électriques de la bobine secondaire (7), le modulateur d'amplitude (13) et/ou le modulateur de phase (14) pouvant être chacun commandés par au moins un signal de modulation de manière à pouvoir générer une bande latérale du champ magnétique alternatif d'une amplitude plus grande que celle de l'autre bande latérale.

15. Procédé pour moduler un champ magnétique alternatif externe d'une station (1), qui comprend une bobine primaire, ayant un signal de modulation généré par une bobine secondaire d'un circuit de réponse (2) en tant que signal de données, la bobine primaire et la bobine secondaire étant rapprochées de façon à coopérer par induction, **caractérisé en ce que** la modulation est effectuée de façon à générer une bande latérale du champ magnétique alternatif modulé d'une amplitude plus grande que celle de l'autre bande latérale.

16. Procédé selon la revendication 15, **caractérisé en ce que** le champ magnétique alternatif est modulé aussi bien en amplitude qu'en phase.

17. Procédé selon la revendication 16, **caractérisé en ce que** la modulation d'amplitude est déphasée par rapport à la modulation de phase.

18. Procédé selon la revendication 17, **caractérisé en ce que** le déphasage est de 90°, et ce avec une avance de phase ou un retard de phase.

19. Procédé selon l'une des revendications 15 à 18, **caractérisé en ce que** la modulation d'amplitude est effectuée au moyen d'un modulateur d'amplitude (13) commandé par un signal de modulation d'amplitude, et **en ce que** la modulation de phase est effectuée au moyen d'un modulateur de phase (14) commandé par un signal de modulation de phase, le signal de modulation d'amplitude et/ou le signal de modulation de phase étant l'un et l'autre générés en modulant le signal de données par une porteuse auxiliaire correspondante.

20. Procédé selon la revendication 19, **caractérisé en ce que** la porteuse auxiliaire ou les porteuses auxiliaires dérivent du champ magnétique alternatif par division de fréquence.

21. Procédé selon la revendication 19 ou la revendication 20, **caractérisé en ce que** les porteuses auxiliaires sont générées avec un déphasage entre elles, en particulier de 90°.
